# EUROPÄISCHE PATENTSCHRIFT

(11) **EP 0 723 668 B1**
(45) Veröffentlichungstag und Bekanntmachung des Hinweises auf die Patenterteilung: **06.08.1997**
(21) Anmeldenummer: 94928767.6
(22) Anmeldetag: 06.10.1994
(51) Int. Cl.: G01R 31/316, G01R 31/27

(54) **ANORDNUNG ZUM PRÜFEN EINES GATEOXIDS**
ARRANGEMENT FOR TESTING A GATE OXIDE
ARRANGEMENT DE CONTROLE D'OXYDES DE GRILLES

(30) Priorität: 13.10.1993 DE 4334856
(43) Veröffentlichungstag der Anmeldung: 31.07.1996
(73) Patentinhaber: ROBERT BOSCH GMBH, 70442 Stuttgart (DE)
(72) Erfinder: BRAUCHLE, Peter, D-72147 Nehren (DE)
(74) Vertreter: Friedmann, Jürgen, Dr.-Ing.
(86) Internationale Anmeldenummer: DE9401199
(87) Internationale Veröffentlichungsnummer: WO9510785

(56) Entgegenhaltungen:
- EP-A- 0 078 670
- PATENT ABSTRACTS OF JAPAN vol. 15, no. 62 (E-1033) 14. Februar 1991 & JP,A,02 288 366 (NIPPONDENSO) 28. November 1990
- IBM TECHNICAL DISCLOSURE BULLETIN, Bd.31, Nr.2, Juli 1988, NEW YORK US Seiten 223 - 224 'CMOS-TTL PROTECTIVE CIRCUIT'
- PATENT ABSTRACTS OF JAPAN vol. 17, no. 386 (E-1401) 20. Juli 1993 & JP,A,05 067 661 (NIPPONDENSO) 19. März 1993

## Beschreibung

Die Erfindung betrifft eine Anordnung zum Prüfen eines Gateoxids eines in einer monolithisch integrierten Schaltung integrierten Power-Bauelementes in MOS-Technik.

### Stand der Technik

Es sind bereits integrierte Schaltungen bekannt, die mit einer Power-MOS-Endstufe kombiniert sind, und die in einem einzigen, einkristallinen, aus Silicium bestehenden Halbleiterkörper untergebracht sind. Da bei späteren Anwendungen die Sperrfähigkeit des Gateoxids der Power-MOS-Endstufe durch Alterungsprozesse abnehmen kann, ist es notwendig, das Gateoxid einer Prüfung zu unterziehen. Das Prüfen des Gateoxids erfolgt dabei in der Form, daß das Gateoxid mit einer Spannung beaufschlagt wird, die höher ist als die, die in der späteren Anwendung auftreten. Üblicherweise werden Gateoxide mit einer Stärke von ungefähr 50 Nanometer eingesetzt. Diese Gateoxide haben einen intrinsischen Durchbruch bei einer Spannung von ungefähr 45 Volt. Dies bedeutet, bei höheren Spannungen würde ein elektrischer Durchschlag erfolgen, der zu Feldausfällen und damit zu einer Zerstörung der Power-MOS-Endstufe führen würde. Bei den Anwendungen wird die Gatespannung auf U_{G} kleiner gleich 15 Volt begrenzt. Werden diese Gates nun mit einer Gatespannung von U_{G} = 25 Volt getestet, wird erreicht, daß nur solche Power-MOS-Endstufen als zuverlässig erkannt werden, bei denen Schwachstellen nicht zu Feldausfällen führen, sofern die Sperrfähigkeit im Laufe der Lebensdauer nicht mehr als 10 Volt abnimmt.

Diese Vorgehensweise einer Prüfung ist bei diskreten Power-MOS-Bauelementen ohne weiteres möglich, da das Gate direkt als Meßpad zugänglich ist. Somit kann beim Wafermessen das Gateoxid direkt mit einer höheren Spannung auf Sperrfähigkeit geprüft werden, als später in der Anwendung auftritt. Bei monolithisch integrierten Schaltungen mit integrierten Power-MOS-Bauelementen ist hingegen die erwähnte Prüfung nicht möglich, da das Gate des Power-MOS-Bauelementes innerhalb des Chips angeordnet ist und nicht für Messungen mit überhöhter Spannung frei zugänglich ist. Ein Durchmessen der gesamten integrierten Schaltung mit einer überhöhten Spannnung würde zur Zerstörung der weiteren Bauelemente der integrierten Schaltung führen. Dies können beispielsweise gerade zu einem Überspannungsschutz des Power-MOS-Bauelementes eingesetzte Schutzstrukturen, beispielsweise Zenerdioden, sein.

Weiterhin ist bereits bekannt, eine Gateoxidprüfung bei integrierten Schaltungen derart durchzuführen, daß die Gateoxidqualität mit Hilfe von Teststrukturen beurteilt wird. Hierbei ist jedoch nachteilig, daß auf den Wafern eine zusätzliche große Fläche vorgesehen sein muß, die anstelle der integrierten Gateoxide einer Prüfung unterzogen wird. Diese Messung über Teststrukturen ist jedoch wirtschaftlich nicht sinnvoll, da für eine statistisch fundierte Aussage über die Gateoxidqualität zu viel Fläche auf dem Wafer benötigt wird.

Aus der Zusammenfassung der Schrift JP-A-2288366 ist eine Anordnung zum Prüfen des Gate eines MOS-Bauelements bekannt, welche einen Steueranschluß und einen Prüfanschluß aufweist. Der Prüfanschluß ist unmittelbar mit dem Gate verbunden. Der Prüfanschluß ist über eine Zenerdiode und einen Widerstand, die zueinander parallelgechaltet sind, mit einem Knoten verbunden. Weiterhin ist der Steueranschluß über einen weiteren Widerstand mit dem Knoten verbunden. Weiterhin ist der Knoten über eine Klammerschaltung mit dem Source-Anschluß des MOS-Bauelements verbunden. Da der Prüfanschluß durch die Zenerdiode und den Widerstand von der Klammerschaltung entkoppelt ist, kann das Gate des MOS-Bauelements mit einem höheren Prüfpotential beaufschlagt werden, als dies bei der Beaufschlagung des Steueranschlusses möglich wäre.

### Vorteile der Erfindung

Die Anordnung zum Prüfen eines Gateoxids mit den im Anspruch 1 genannten Merkmalen hat demgegenüber den Vorteil, daß einerseits eine Gateoxidprüfung mit einer ausreichend großen Prüfspannung durchgeführt werden kann, ohne daß die weiteren in der integrierten Schaltung angeordneten Bauelemente übermäßig belastet werden und daß andererseits auf die zusätzliche Anordnung von Teststrukturen auf dem entsprechenden Wafer verzichtet werden kann. Dadurch, daß zwischen dem Gateoxid des Power-Bauelementes und der integrierten Schaltung eine Reihenschaltung eines ersten Meßpads, eines Widerstandes und eines zweiten Meßpads angeordnet ist, kann an das erste Meßpad eine entsprechend hohe Gateprüfspannung angelegt werden, während an das zweite Meßpad eine Anwender- bzw. Betriebsspannung angelegt werden kann und die Differenz zwischen der Gatemeßspannung und der Anwenderspannung von dem Widerstand aufgenommen wird. Hierdurch wird in einfacher Weise erreicht, daß das Gateoxid der Power-MOS-Endstufe mit einer ausreichend hohen Prüfspannung geprüft werden kann, die - wie bereits erwähnt - gewährleistet, daß bei ausgelieferten Bauelementen während der späteren Anwendung keine Schwachstellen vorhanden sind, die zu Feldausfällen führen können. Durch die Aufnahme der Spannungsdifferenz zwischen der Gateprüfspannung und der Betriebsspannung durch den Widerstand wird der übrige Teil der integrierten Schaltung vor der eine Überspannung bedeutenden Gateprüfspannung geschützt, so daß Beeinträchtigungen nicht möglich sind.

Weitere vorteilhafte Ausgestaltungen der erfindungsgemäßen Anordnung ergeben sich aus den übrigen in den Unteransprüchen genannten Merkmalen.

### Zeichnung

Die Erfindung wird nachfolgend in Ausführungsbeispielen anhand der zugehörigen Zeichnungen näher erläutert. Es zeigen:
- Figur 1: eine Schaltungsanordnung einer integrierten Schaltung mit einer Anordnung zum Prüfen eines Gateoxids,
- Figur 2: eine Schaltungsanordnung in einer weiteren Ausführungsvariante,
- Figur 3: eine Schaltungsanordnung in einer weiteren Ausführungsvariante und
- Figur 4: eine Schaltungsanordnung in einer weiteren Ausführungsvariante.

### Beschreibung der Ausführungsbeispiele

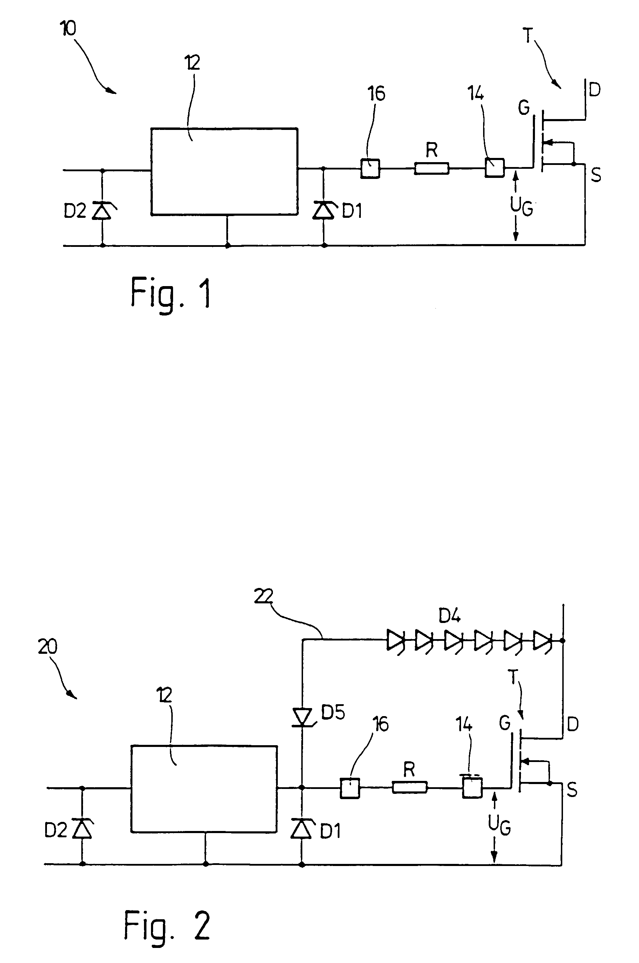

In der Figur 1 ist eine Schaltungsanordnung 10 gezeigt, die eine hier nicht näher spezifizierte integrierte Schaltung 12, beispielsweise eine Logikschaltung, aufweist. Die Schaltungsanordnung 10 besitzt weiterhin einen MOSFET-Leistungstransistor T, dessen Source-Anschlußklemme mit S, dessen Drain-Anschlußklemme mit D und dessen Gate mit G bezeichnet ist. Zwischen dem Gate G des Transistors T und der integrierten Schaltung 12 ist eine Reihenschaltung aus einem ersten Meßpad 14, einem Polywiderstand R und einem zweiten Meßpad 16 angeordnet. Mit Meßpad wird hier eine Metallfläche bezeichnet, die zum Aufsetzen von Nadelelektroden zum Anlegen einer Prüfspannung geeignet ist und nach außerhalb des Chips geführt ist. Weiterhin sind zwei Zenerdioden D1 und D2 parallel zu der integrierten Schaltung 12 angeordnet, die eine Durchbruchspannung von beispielsweise 8 V besitzen und einen hier nicht weiter zu betrachtenden Überspannungsschutz für die integrierte Schaltung 12 bilden. Die Prüfung des Gateoxids des Gates G erfolgt nun dadurch, daß zwischen dem ersten Meßpad 14 und der Source-Anschlußklemme S eine GatePrüfspannung U_{G} angelegt wird. Diese GatePrüfspannung U_{G} kann beispielsweise 25 V betragen. Da die Anwendungsspannung im Beispiel 8 V beträgt, kann die integrierte Schaltung 12 vor Überlastung dadurch geschützt werden, daß an den zweiten Meßpad 16 eine Spannung angelegt wird, die kleiner als 8 V ist. Die Differenz zwischen der Gatemeßspannung U_{G} und der Anwendungsspannung wird dabei von dem zwischen den Meßpads 14 und 16 angeordneten Polywiderstand R aufgenommen. Hiermit ist also gewährleistet, daß einerseits das Gateoxid des Gates G mit der erhöhten Prüfspannung beaufschlagt werden kann und andererseits die übrigen Bestandteile der gesamten Schaltungsanordnung 10, insbesondere die integrierte Schaltung 12, vor einer Überlastung durch die überhöhte Gateprüfspannung U_{G} geschützt ist. Hingegen kann das Gateoxid mit einem notwendigen Sicherheitsabstand zu der eigentlichen Sperrspannung geprüft werden, so daß solche integrierten Schaltungen aussortiert werden können, bei denen die Sperrfähigkeit des Gateoxids, beispielsweise durch Alterungsprozesse, soweit abnehmen kann, daß Schwachstellen zu Feldausfällen führen können.

In der Figur 2 ist eine Schaltungsanordnung 20 gezeigt, bei der zusätzlich zu der in Figur 1 gezeigten Schaltungsanordnung eine Schutzstruktur zum Schutz des MOSFET-Transistors T vor Überspannungen angeordnet ist. Diese als Klammerzweig 22 bezeichnete Schutz struktur besteht aus einer Reihenschaltung von Zenerdioden D4 und einer zu diesen antiparallel geschalteten Zenerdioden D5. Der Aufbau der weiteren Schaltung ist der gleiche wie in Figur 1 und hier nicht nochmals erläutert. In der gezeigten Variante greift der Klammerzweig 22 zwischen dem Meßpad 16 und der integrierten Schaltung 12 an. Somit kann bei dieser Anordnung die Prüfung des Gateoxids in der gleichen Weise durchgeführt werden wie bereits in Figur 1 beschrieben. Dieses ist insbesondere deshalb möglich, da durch Anlegen einer mit der integrierten Schaltung 12 verträglichen Spannnung an den Meßpad 16 der Klammerzweig 22 gleichzeitig vor der höheren Gatemeßspannung U_{G}, die am Meßpad 14 anliegt, geschützt ist.

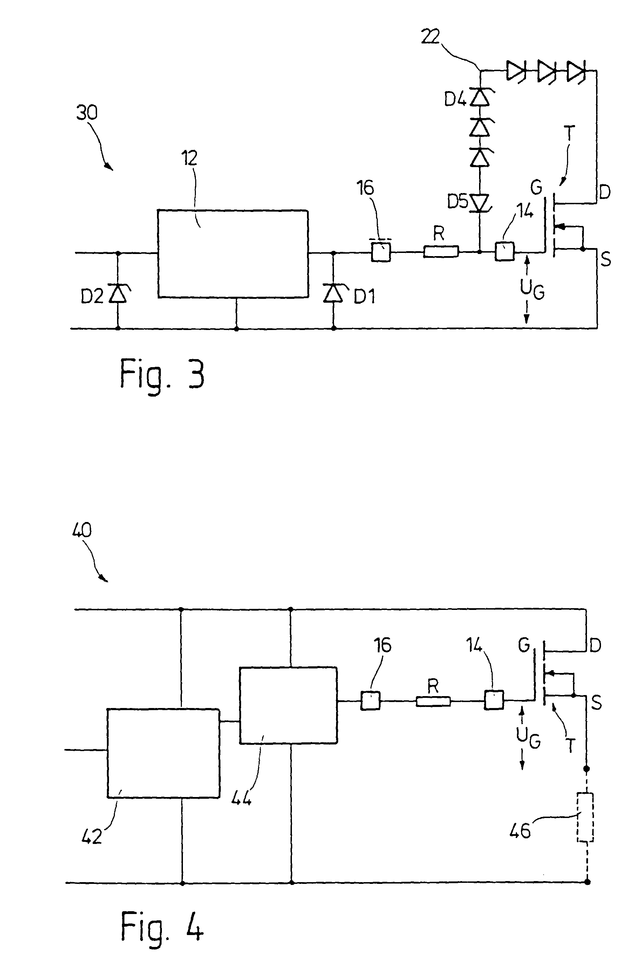

Bei der in Figur 3 gezeigten Schaltungsanordnung 30, die analog der in Figur 2 gezeigten Schaltungsanordnung 20 aufgebaut ist, wobei gleiche Teile wiederum mit gleichen Bezugszeichen versehen sind, greift der Klammerzweig 22 direkt am Gate G des Transistors T an. Da der Klammerzweig 22 eine Überspannungsschutzfunktion, das heißt eine Spannungsbegrenzung für den Transistor T, darstellt, wird in diesem Fall die Höhe der Gateprüfspannung U_{G} durch die Sperrfähigkeit der antiparallel geschalteten Diode D5 begrenzt.

Bei den in den Figuren 1 bis 3 gezeigten Schaltungsanordnungen muß beachtet werden, daß durch die zusätzliche Anordnung des Polywiderstandes R die Schaltgeschwindigkeit des Transistors T beeinflußt wird, so daß dies bei der Dimensionierung der Bauelemente entsprechend berücksichtigt werden muß. Darüber hinaus muß durch die Anordnung des Polywiderstandes R bei einer Schaltungsanordnung mit einem Klammerzweig 22 beachtet werden, daß durch den Polywiderstand R die Funktion des Klammerzweiges 22, das heißt die Reaktionsfähigkeit auf eine auftretende Überspannung, verlangsamt wird.

In der Figur 4 ist eine spezielle Schaltungsanordnung 40 gezeigt, bei der der MOSFET-Transistor T als High-Side-Schalter ausgebildet ist. Hierbei ist eine integrierte Schaltung 42 vorgesehen, die über eine Ladungspumpe 44 und der Reihenschaltung aus dem ersten Meßpad 14, dem Polywiderstand R und dem zweiten Meßpad 16 an dem Gate G des Transistors T angreift. Durch Schalten des Transistors T kann hier in nicht näher zu betrachtender Weise eine externe Last 46 ein- bzw. ausgeschaltet werden. Das Prüfen der Gateoxidqualität des Gates G erfolgt, wie bereits zu der Figur 1 beschrieben, durch Anlegen einer Gateprüfspannung U_{G} an den Meßpad 14, während ein Begrenzen auf eine für die integrierte Schaltung 42 bzw. die Ladungspumpe 44 verträgliche Spannung durch Anlegen eines entsprechend niederen Potentials an dem Meßpad 16 erfolgt.

Die Erfindung beschränkt sich nicht auf die dargestellten Ausführungsbeispiele, sondern ist selbstverständlich überall dort anwendbar, wo die Gateoxidqualität getestet werden soll. Dies können beispielsweise auch Smart-Power-Schaltkreise mit mehreren integrierten Power-MOS-Endstufen sein, die dann jeweils einzeln nach der beschriebenen Prüfmethode getestet werden können.

## Patentansprüche

1. Schaltungsanordnung (10, 20, 30, 40) mit einem integrierten Power-Bauelement (T) in MOS-Technik, wobei ein Gate des Power-Bauelements mit einem ersten Meßpad (14) und der erste Meßpad (14) mit einem Widerstand (R) verbunden sind, wobei der erste Meßpad (14) mit einer Gateprüfspannung (U_{G}) beaufschlagbar ist, die größer ist als eine zum Betrieb des Bauelements (T) erforderliche Gatespannung, dadurch gekennzeichnet,
daß das Bauelement (T) gemeinsam mit einer integrierten Schaltung (12, 42, 44) auf einem Chip integriert ist, daß die integrierte Schaltung (12, 42, 44) mit einem zweiten Meßpad (16) und der zweite Meßpad (16) mit dem Widerstand (R) verbunden ist, und daß der zweite Meßpad (16) mit einer externen, für die integrierte Schaltung (12, 42, 44) verträglichen Spannung (U) beaufschlagbar ist.

2. Anordnung nach Anspruch 1, **dadurch gekennzeichnet,** daß die Gateprüfspannung (U_{G}) und die Spannung (U) gleichzeitig anliegen.

3. Anordnung nach einem der vorhergehenden Ansprüche, **dadurch gekennzeichnet,** daß die Gateprüfspannung ein Vielfaches der Betriebsspannung des Power-Bauelementes (T) beträgt.

4. Anordnung nach einem der vorhergehenden Ansprüche, **dadurch gekennzeichnet,** daß eine Spannungsbegrenzungsschaltung (22) des Power-Bauelementes (T) zwischen dem zweiten Meßpad (16) und der integrierten Schaltung (12) angreift.

5. Anordnung nach Ansprüche 1-3, **dadurch gekennzeichnet,** daß eine Spannungsbegrenzungsschaltung (22) des Power-Bauelementes (T) zwischen dem ersten Meßpad (14) und dem Widerstand (R) angreift.

## Claims

1. Circuit arrangement (10, 20, 30, 40) having an integrated power component (T) using MOS technology, a gate of the power component being connected to a first measurement pad (14) and the first measurement pad (14) being connected to a resistor (R), it being possible to apply to the first measurement pad (14) a gate test voltage (Ug) which is greater than a gate voltage required for the operation of the component (T) characterized in that the component (T) is integrated together with an integrated circuit (12, 42, 44) on a chip, in that the integrated circuit (12, 42, 44) is connected to a second measurement pad (16) and the second measurement pad (16) is connected to the resistor (R), and in that it is possible to apply to the second measurement pad (16) an external voltage (U), which is compatible for the integrated circuit (12, 42, 44).

2. Arrangement according to Claim 1, characterized in that the gate test voltage (U_{G}) and the voltage (U) are applied simultaneously.

3. Arrangement according to one of the preceding claims, characterized in that the gatetestvoltage is a multiple of the operating voltage of the power component (T).

4. Arrangement according to one of the preceding claims, characterized in that a voltage limiting circuit (22) of the power component (T) acts between the second measurement pad (16) and the integrated circuit (12).

5. Arrangement according to preceding Claims 1-3, characterized in that a voltage limiting circuit (22) of the power component (T) acts between the first measurement pad (14) and the resistor (R).

## Revendications

1. Circuit (10, 20, 30, 40) comprenant un composant de puissance (T), intégré en technique MOS, une grille du composant de puissance étant reliée à un premier chemin de mesure (14) et ce dernier étant relié à une résistance (R), le premier chemin de mesure (14) recevant une tension de contrôle de grille (U_{G}) supérieure à une tension de grille nécessaire pour le fonctionnement du composant (T),
caractérisé en ce que
• le composant (T) est intégré en commun, sur une plaquette, avec un circuit intégré (12, 42, 44),
• le circuit intégré (12, 42, 44) est relié à un second chemin de mesure (16) et le second chemin de mesure (16) est relié à la résistance (R), et
• le second chemin de mesure (16) est sollicité par une tension externe (U) acceptable pour le circuit intégré (12, 42, 44).

2. Circuit selon la revendication 1,
caractérisé en ce que
la tension de contrôle de grille (U_{G}) et la tension (U) sont appliquées simultanément.

3. Circuit selon l'une des revendications précédentes,
caractérisé en ce que
la tension de contrôle de grille représente un multiple de la tension de fonctionnement du composant de puissance (T).

4. Circuit selon l'une des revendications précédentes,
caractérisé en ce qu'
un circuit de limitation de tension (22) du composant de puissance (T) est appliqué entre le second chemin de mesure (16) et le circuit intégré (12).

5. Circuit selon les revendications 1 à 3,
caractérisé en ce qu'
un circuit de limitation de tension (22) du composant de puissance (T) est prévu entre le premier chemin de mesure (14) et la résistance (R).
